# EUROPÄISCHE PATENTSCHRIFT

(11) **EP 1 281 222 B1**
(45) Veröffentlichungstag und Bekanntmachung des Hinweises auf die Patenterteilung: **21.04.2004**
(21) Anmeldenummer: 02712773.7
(22) Anmeldetag: 12.02.2002
(51) Int. Cl.: H01S 5/183, H01S 5/04, H01L 33/00

(54) **OPTISCH GEPUMPTE OBERFLÄCHENEMITTIERENDE HALBLEITERLASERVORRICHTUNG UND VERFAHREN ZU DEREN HERSTELLUNG**
OPTICALLY PUMPED SURFACE-EMITTING SEMICONDUCTOR LASER DEVICE AND METHOD FOR THE PRODUCTION THEREOF
SYSTEME LASER A SEMI-CONDUCTEUR A POMPAGE OPTIQUE A EMISSION PAR SURFACE ET PROCEDE PERMETTANT DE LE PRODUIRE

(30) Priorität: 20.02.2001 DE 10108079
(43) Veröffentlichungstag der Anmeldung: 05.02.2003
(73) Patentinhaber: Osram Opto Semiconductors GmbH, 93049 Regensburg (DE)
(72) Erfinder: ALBRECHT, Tony, 93077 Bad Abbach (DE)
(74) Vertreter: Epping Hermann & Fischer
(86) Internationale Anmeldenummer: PCT/DE2002/000508
(87) Internationale Veröffentlichungsnummer: WO 2002/067393

(56) Entgegenhaltungen:
- WO-A-01/93386
- US-A- 4 380 076
- US-A- 5 748 653
- US-A- 5 796 771
- PATENT ABSTRACTS OF JAPAN vol. 1996, no. 01, 31. Januar 1996 (1996-01-31) -& JP 07 249824 A (HITACHI LTD), 26. September 1995 (1995-09-26)
- GERHOLD M D ET AL: "NOVEL DESIGN OF A HYBRID-CAVITY SURFACE-EMITTING LASER" IEEE JOURNAL OF QUANTUM ELECTRONICS, IEEE INC. NEW YORK, US, Bd. 34, Nr. 3, 1. März 1998 (1998-03-01), Seiten 506-510, XP000742645 ISSN: 0018-9197

## Beschreibung

Optisch gepumpte oberflächenemittierende Halbleiterlaservorrichtung und Verfahren zu deren Herstellung

Die Erfindung bezieht sich auf eine optisch gepumpte Halbleiterlaservorrichtung nach dem Oberbegriff des Patentanspruchs 1 und ein Verfahren zu deren Herstellung.

Die Erfindung betrifft eine optisch gepumpte oberflächenemittierende Halbleiterlaservorrichtung mit mindestens einer strahlungserzeugenden Quantentopfstruktur und mindestens einer Pumpstrahlungsquelle zum optischen Pumpen der Quantentopfstruktur, wobei die Pumpstrahlungsquelle eine kantenemittierende Halbleiterstruktur aufweist. Die strahlungserzeugende Quantentopfstruktur und die kantenemittierende Halbleiterstruktur sind dabei auf einem gemeinsamen Substrat epitaktisch aufgebracht.

Die Pumpstrahlungsquelle kann einen oder mehrere Halbleiterlasern enthalten. Der Resonator solcher Laser entspricht üblicherweise einem (linearen) Fabry-Perot-Resonator und wird vorzugsweise von zwei hochreflektierenden Spiegelschichten begrenzt. Die Pumpeffizienz dieser Halbleiterlaser wird maßgeblich von der Qualität der Spiegel beeinflußt. Eine Verringerung der Reflektivität dieser Spiegel, beispielsweise durch Alterung oder Strahlungsschäden, reduziert zunächst die zur Verfügung stehende optische Pumpleistung und führt in der Folge zu einer erheblich geringeren Besetzungsinversionsdichte bzw. Strahlungsausbeute bei der Quantentopfstruktur.

Aufgabe der Erfindung ist es, eine optisch gepumpte Halbleiterlaservorrichtung der eingangs genannten Art mit verbesserter Pumpstrahlungsquelle zu schaffen. Weiterhin ist es Aufgabe der Erfindung, ein Herstellungsverfahren hierfür anzugeben.

Diese Aufgabe wird durch eine Halbleiterlaservorrichtung nach Patentanspruch 1 bzw. ein Verfahren nach Patentanspruch 8 oder 9 gelöst. Vorteilhafte Weiterbildungen der Erfindungen sind Gegenstand der Unteransprüche 2 bis 7 und 10.

Erfindungsgemäß ist vorgesehen, daß bei einer optisch gepumpten oberflächenemittierenden Halbleiterlaservorrichtung mit mindestens einer strahlungserzeugenden Quantentopfstruktur und mindestens einer Pumpstrahlungsquelle zum Pumpen der Quantentopfstruktur die Pumpstrahlungsquelle eine kantenemittierende Halbleiterstruktur aufweist, wobei diese Halbleiterstruktur mindestens einen Ringlaser enthält. Unter einem Ringlaser ist dabei eine Laserstruktur zu verstehen, bei der sich im Betrieb Ringmoden ausbilden können. Die Ausbildung des Laserresonators in Ringform ist dabei, wie im folgenden noch erläutert wird, vorteilhaft, jedoch nicht zwingend erforderlich.

Der Resonator eines solchen Ringlasers kann mittels totalreflektierender Grenzflächen gebildet werden, so daß vorteilhafterweise keine hochreflektierenden Spiegel erforderlich sind. Damit wird auch die Gefahr einer geringeren Strahlungsausbeute aufgrund von Schäden an den Spiegeln reduziert. Weiterhin zeichnet sich ein Ringlaser durch ein vorteilhaft großes Modenvolumen und eine hohe Modenstabilität aus.

Bevorzugt ist die Quantentopfstruktur innerhalb des Ringresonators angeordnet, so daß das gesamte resonatorinterne Strahlungsfeld zum Pumpen der Quantentopfstruktur zur Verfügung steht. Besonders vorteilhaft ist es hierbei, die aktive Schicht der kantenemittierenden Halbleiterstruktur und die Quantentopfstruktur in derselben Höhe über dem Substrat anzuordnen, so daß sich ein großer Überlapp zwischen dem zu pumpenden Volumen der Quantentopfstruktur und dem Strahlungsfeld der kantenemittierenden Halbleiterstruktur und damit eine hohe Pumpeffizienz ergibt.

Bei einer vorteilhaften Weiterbildung der Erfindung wird der Resonator des Ringlasers von einem ringförmig geschlossenen Wellenleiter gebildet. Die Führung des Pumpstrahlungsfeldes erfolgt darin durch Totalreflexion an den Begrenzungen des Wellenleiters, so daß auch hier vorteilhafterweise keine hochreflektierenden Spiegel benötigt werden. Weiterhin kann durch die Formgebung des ringförmig geschlossenen Wellenleiter das Pumpstrahlungsfeld sehr gut an das zu pumpende Volumen der Quantentopfstruktur angepaßt werden.

Die kantenemittierende Halbleiterstruktur ist bei einer bevorzugten Ausgestaltung der Erfindung von einem Medium umgeben, dessen Brechungsindex geringer ist als der Brechungsindex der Halbleiterstruktur. Dadurch entsteht an dem Übergang vom Halbleiter in das optisch dünnere, umgebende Medium eine totalreflektierende Fläche, die als Begrenzung des Laserresonators dient. Zur Bildung eines ringförmig geschlossenen Wellenleiters kann innerhalb der kantenemittierenden Halbleiterstruktur eine mit einem optisch dünneren Medium gefüllte Ausnehmung angeordnet sein.

Als umgebendes Medium eignet sich aufgrund des geringen Brechungsindex insbesondere Luft oder ein anderes gasförmiges Medium. Alternativ kann die kantenemittierende Halbleiterstruktur auch von einem anderen Material wie beispielsweise einem Halbleitermaterial, einem Halbleiteroxid oder einem Dielektrikum mit geringerem Brechungsindex umschlossen sein.

Bevorzugt ist die Halbleiterstruktur als zylindrischer Stapel kreisförmiger oder ringförmiger Halbleiterschichten gebildet. Der so geformte zylindrische Halbleiterkörper stellt zugleich den Ringlaserresonator dar, an dessen Mantelflächen das Strahlungsfeld totalreflektierend geführt wird.

Alternativ kann die Halbleiterstruktur auch prismatisch als Stapel von Halbleiterschichten in Form von Vielecken oder Vieleckringen gebildet sein. Durch diese Formgebung kann eine weitgehend homogene Strahlungsverteilung und entsprechend eine weitgehend homogene Pumpdichte in der Quantentopfstruktur erzielt werden.

Ein Stapel von Halbleiterschichten der beschriebenen Form kann vergleichsweise einfach, zum Beispiel durch Ätzen aus einer zuvor epitaktisch hergestellten Halbleiterschichtenfolge gebildet werden. Vorteilhafterweise wird so mit der Formung des Halbleiterkörpers zugleich auch der Laserresonator der kantenemittierenden Halbleiterstruktur gebildet, ohne daß zusätzliche Verspiegelungen erforderlich sind.

Bei einem erfindungsgemäßen Herstellungsverfahren wird zunächst auf einem Substrat eine oberflächenemittierende Halbleiterschichtenfolge mit mindestens einer Quantentopfstruktur aufgebracht, die Schichtenfolge außerhalb des vorgesehenen Laserbereichs entfernt und die kantenemittierende Halbleiterstruktur der Pumpstrahlungsquelle auf den dadurch freigelegten Bereich aufgebracht.

Daraufhin wird der Außenbereich der kantenemittierenden Halbleiterstruktur zur Formung des Laserresonators entfernt. Bevorzugt wird dabei auch ein zentraler Teilbereich im Inneren der Halbleiterstruktur zur Bildung eines Ringresonators abgetragen. Die Entfernung dieser Teilbereiche kann beispielsweise mittels eines Trockenätzverfahrens erfolgen. Mit Vorteil ist keine aufwendige Nachbearbeitung der geätzten Flächen erforderlich.

Alternativ können bei dem erfindungsgemäßen Herstellungsverfahren die Verfahrensschritte in anderer Reihenfolge angewendet werden. Beispielsweise kann auf dem Substrat zunächst eine kantenemittierende Halbleiterstruktur aufgebracht werden, die dann im vorgesehenen Laserbereich der (noch zu bildenden) Quantentopfstruktur abgetragen wird. Auf den freigelegten Bereich wird im nächsten Schritt die oberflächenemittierende Halbleiterschichtenfolge mit mindestens einer Quantentopfstruktur aufgebracht. Abschließend wird wieder der Außenbereich der kantenemittierenden Halbleiterstruktur zur Formung des Laserresonators entfernt. In einer Variante des Verfahrens kann die Formung des Laserresonators auch vor der Aufbringung der oberflächenemittierenden Halbleiterschichtenfolge stattfinden.

Weitere Merkmale, Vorteile und Zweckmäßigkeiten der Erfindung werden nachfolgend anhand von vier Ausführungsbeispielen in Verbindung mit den Figuren 1 bis 4 erläutert. Es zeigen
Figur 1a und 1b eine schematische Schnittdarstellung bzw. eine schematische Aufsicht eines ersten Ausführungsbeispiels einer erfindungsgemäßen Halbleiterlaservorrichtung,
Figur 2 eine schematische Aufsicht eines zweiten Ausführungsbeispiels einer erfindungsgemäßen Halbleiterlaservorrichtung,
Figur 3 eine schematische Aufsicht eines dritten Ausführungsbeispiels einer erfindungsgemäßen Halbleiterlaservorrichtung und
Figur 4 eine schematische Darstellung eines erfindungsgemäßen Herstellungsverfahrens.

Gleiche oder gleich wirkende Elemente sind in den Figuren der Ausführungsbeispiele mit denselben Bezugszeichen versehen.

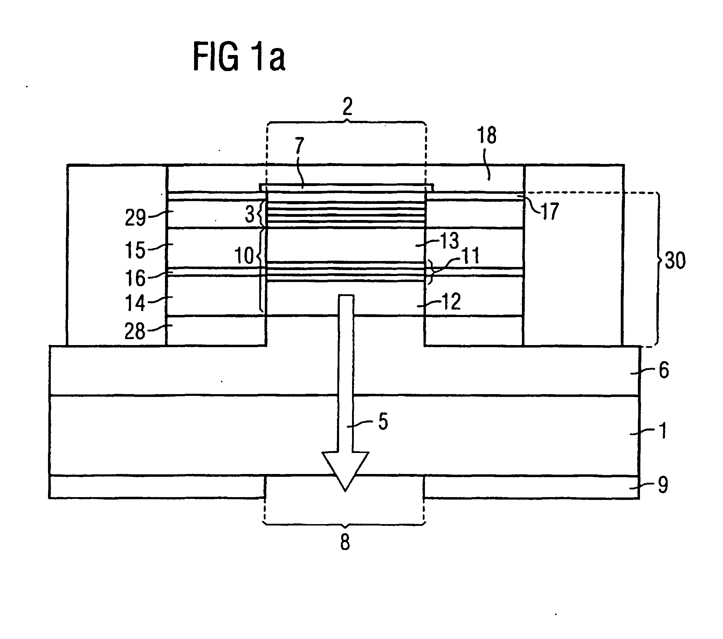

In Figur 1a ist ein Schnitt durch einen optisch gepumpten oberflächenemittierenden Halbleiterlaserchip mit einer Laseremission bei 1030 nm dargestellt. Bei diesem ist auf einem Substrat 1 eine Bufferschicht 6 aufgebracht. Das Substrat 1 besteht beispielsweise aus GaAs und die Bufferschicht 6 aus undotiertem GaAs.

Auf der Bufferschicht 6 ist in der Schnittdarstellung mittig über dem Substrat 1 eine oberflächenemittierende Halbleiterlaserstruktur 10 mit einer Quantentopfstruktur 11 aufgebracht, die den oberflächenemittierenden Laserbereich 2 festlegt. Die Halbleiterlaserstruktur 10 setzt sich zusammen aus einer unmittelbar auf der Bufferschicht befindlichen ersten Confinementschicht 12, einer auf dieser angeordneten Quantentopfstruktur 11 und einer auf der Quantentopfstruktur 11 aufgebrachten zweiten Confinementschicht 13. Die Confinementschichten 12 und 13 bestehen beispielsweise aus undotiertem GaAs und die Quantentopfstruktur 11 weist zum Beispiel eine Mehrzahl (≥ 3) von Quantentöpfen (quantum wells) auf, die aus undotiertem InGaAs bestehen und deren Dicke auf die Emission bei 1030 nm eingestellt ist. Zwischen den Quantentöpfen befinden sich Barriereschichten aus GaAs.

Über der oberflächenemittierenden Halbleiterlaserstruktur ist ein Bragg-Spiegel 3 mit beispielsweise 28 bis 30 Perioden mit je einer GaAlAs(10%Al)-Schicht und einer GaAlAs(90%Al)-Schicht abgeschieden, der einen hochreflektiven Resonatorspiegel darstellt.

Der für den Laserbetrieb der oberflächenemittierenden Halbleiterlaserstruktur 10 erforderliche zweite Spiegel ist bei dem gezeigten Ausführungsbeispiel nicht in den Halbleiterkörper integriert, sondern als externer Spiegel vorgesehen. Alternativ kann dieser zweite Spiegel auch in ähnlicher Weise wie der Spiegel 3 in nicht dargestellter Weise in dem Halbleiterkörper ausgebildet sein. In diesem Fall wäre der zweite Spiegel beispielsweise innerhalb des vorgesehenen Laserbereichs 2 zwischen der Bufferschicht 6 und der Quantentopfstruktur 11 anzuordnen.

In der Umgebung des Laserbereichs 2 ist auf der Bufferschicht 6 eine kantenemittierende Halbleiterlaserstruktur 30 in Form eines Ringlasers abgeschieden. Die Emissionswellenlänge dieses Ringlasers liegt bei etwa 1 µm.

Die Ringlaserstruktur setzt sich im Einzelnen zusammen aus einer ersten Mantelschicht 28 (z.B. n-GaAl_{0.65}As), einer ersten Wellenleiterschicht 14 (z.B. n-GaAl_{0.1}As), einer aktiven Schicht 16 (z.B. single quantum well aus undotiertem InGaAs), einer zweiten Wellenleiterschicht 15 (z.B. p-GaAl_{0.1}As) und einer zweiten Mantelschicht 29 (z.B. p-GaAl_{0.65}As).

Auf der zweiten Mantelschicht 29 kann als Deckschicht 17 beispielsweise eine p⁺-dotierte GaAs-Schicht aufgebracht sein. Im Bereich des Bragg-Spiegels 3 befindet sich auf der Deckschicht 17 eine elektisch isolierende Maskenschicht 7, beispielsweise eine Siliziumnitrid-, Aluminiumoxid- oder eine Siliziumoxidschicht, mit deren Hilfe die Strominjektion in die kantenemittierende Halbleiterstruktur 30 festgelegt wird. Auf der dem Substrat 1 gegenüberliegenden Seite ist die Laservorrichtung von einer gemeinsamen p-Kontaktschicht 18 abgedeckt.

Die von der Halbleiterstruktur abgewandte Hauptfläche des Substrats 1 ist bis auf ein Austrittsfenster 8 für die von der Quantentopfstruktur 11 erzeugte Strahlung 5 mit einer n-Kontaktschicht 9 versehen.

Sämtliche Halbleiterschichten sind beispielsweise mittels metallorganischer Dampfphasenepitaxie (MOVPE) hergestellt.

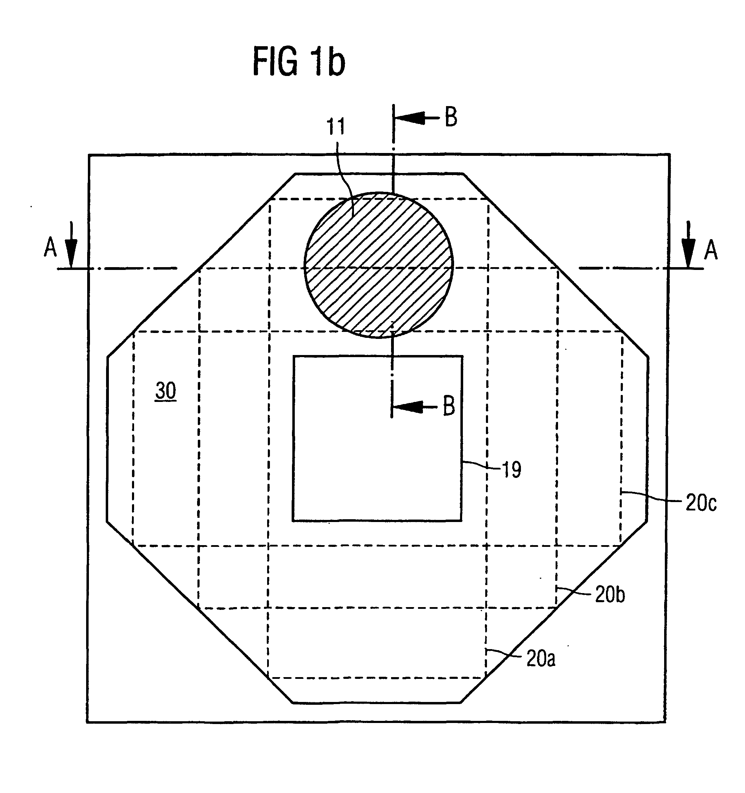

Figur 1b zeigt eine Aufsicht auf das erste Ausführungsbeispiel einer erfindungsgemäßen Halbleiterlaservorrichtung. Die Schnittdarstellung gemäß Figur 1a entspricht einem senkrechten Schnitt entlang der Linie A-A.

Die kantenemittierende Halbleiterstruktur 30 weist in der Aufsicht eine achteckige Form mit vierzähliger Rotationssymmetrie sowie eine quadratische zentrale Aussparung 19 auf. Die zu pumpende, in der Aufsicht kreisförmige Quantentopfstruktur 11 ist vollständig innerhalb des so gebildeten Achteckrings angeordnet. Dieser Achteckring bildet einen Ringresonator in Form eines totalreflektierenden, geschlossenen Wellenleiters.

Im Betrieb schwingen in diesem Wellenleiter zyklisch umlaufende Ringmoden, beispielhaft dargestellt anhand der Moden 20a,b,c, an, die die Quantentopfstruktur 11 optisch pumpen. Aufgrund der Totalreflexion an den Außenflächen sind die Auskoppelverluste bei diesem Ausführungsbeispiel äußerst gering, so daß mit Vorteil das gesamte resonatorinterne Strahlungsfeld zum Pumpen der Quantentopfstruktur 11 zur Verfügung steht.

Aufgrund der gezeigten Formgebung des Achteckrings sind die Ringmoden 20a, 20b und 20c im wesentlichen gleichberechtigt und breiten sich gleichförmig aus. Somit ergibt sich in radialer Richtung (entlang der Linie B-B) ein weitgehend homogenes Strahlungsfeld und entsprechend eine weitgehend gleichmäßige Pumpdichte in der zu pumpenden Quantentopfstruktur 11.

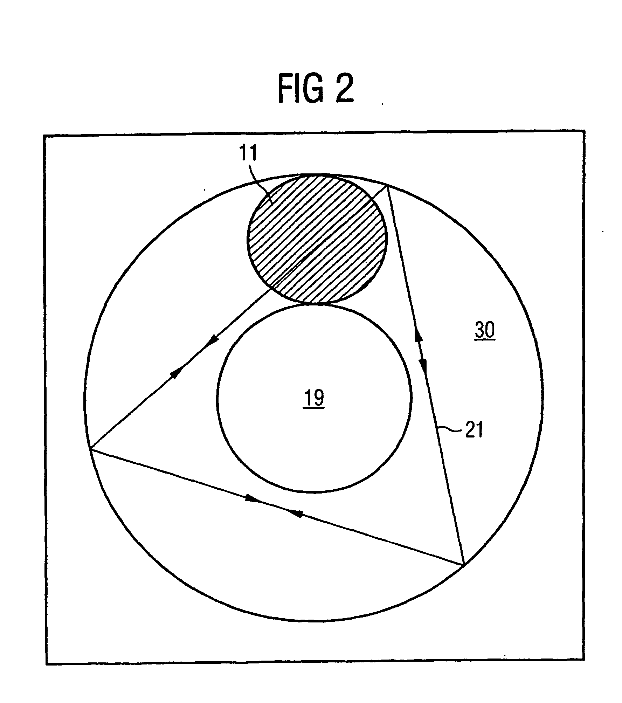

In Figur 2 ist ein weiteres Ausführungsbeispiel einer erfindungsgemäßen Halbleiterlaservorrichtung in Aufsicht gezeigt. Im Unterschied zu dem vorigen Ausführungsbeispiel ist hier der totalreflektierende Wellenleiter als Kreisring gebildet. Die zu pumpende Quantentopfstruktur 11 ist vollständig innerhalb des Ringbereichs angeordnet.

Innerhalb des kreisringförmigen Resonators können eine Vielzahl von Ringmoden anschwingen. Die dargestellt Mode 21 zeigt lediglich ein mögliches Beispiel. Die Quantentopfstruktur 11 wird daneben von einer Vielzahl weiterer Moden mit hoher Effizienz gepumpt.

Wie sich aus Figur 2 ergibt, kann zur Vereinfachung auch auf die zentrale Aussparung 19 verzichtet werden, so daß der Resonator eine Vollkreisfläche als Querschitt aufweist. Dadurch wird mit Vorteil der Herstellungsaufwand reduziert. Allerdings können dann bis zu einem gewissen Grad Moden anschwingen, die durch das Resonatorzentrum verlaufen. Diese Moden werden an der Resonatorbegrenzung nicht totalreflektiert und besitzen daher vergleichsweise hohe Auskoppelverluste, die letztendlich die Pumpeffizienz verringern.

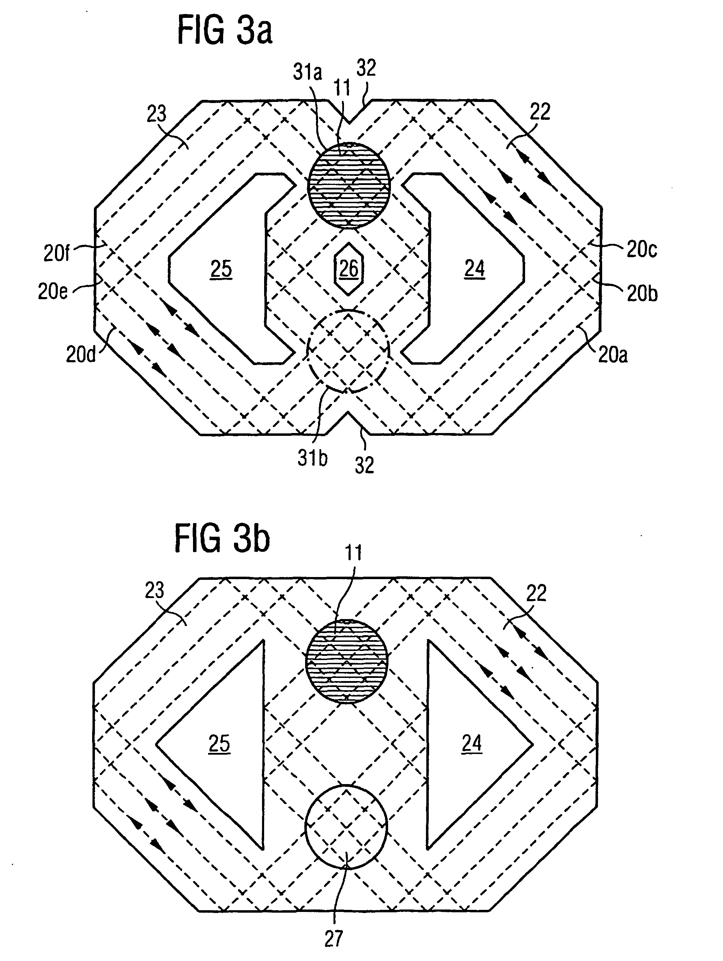

In Figur 3a ist ein weiteres Ausführungsbeispiel der Erfindung gezeigt, bei dem die Quantentopfstruktur 11 von zwei voneinander unabhängigen Ringlasern gepumpt wird. Diese sind prinzipiell wie die Ringlaser des ersten Ausführungsbeispiels aufgebaut.

Die zugehörigen Wellenleiter 22,23 kreuzen sich in zwei Bereichen 31a,b, wobei einem Bereich 31a die zu pumpende Quantentopfstruktur 11 angeordnet ist. Mittels dieser Anordnung mit zwei Ringlasern wird die Pumpdichte in der Quantentopfstruktur 11 weiter erhöht. Die wesentlichen Pumpmoden sind wiederum beispielhaft anhand der Moden 20a,b,c,d,e,f dagestellt. Mit Vorteil ergibt sich wie bei dem ersten Ausführungbeispiel dargelegt auch hier wieder eine weitgehend homogene Pumpdichte.

In Figur 3b ist eine vorteilhafte Variante der in Figur 3a dargestellten Anordnung gezeigt, die sich insbesondere dadurch auszeichnet, daß die Formgebung der sich kreuzenden, ringförmigen Wellenleiter 22 und 23 vereinfacht ist. Dazu sind die Querschnitte der zentralen Ausnehmungen 24 und 25 auf Dreiecke reduziert. Auf die zentrale Ausnehmung 26 und die in Figur 3a dargestellten seitlichen Ausnehmungen 32 wird verzichtet. Durch diese Vereinfachung wird mit Vorteil der Herstellungsaufwand verringert, ohne die Laserfunktion wesentlich zu beeinträchtigen.

Weitergehend könnte auch, wie in Figur 3b angedeutet, eine zweite Quantentopfstruktur 27 in dem zweiten Kreuzungsbereich 31b der beiden Ringlaser ausgebildet sein.

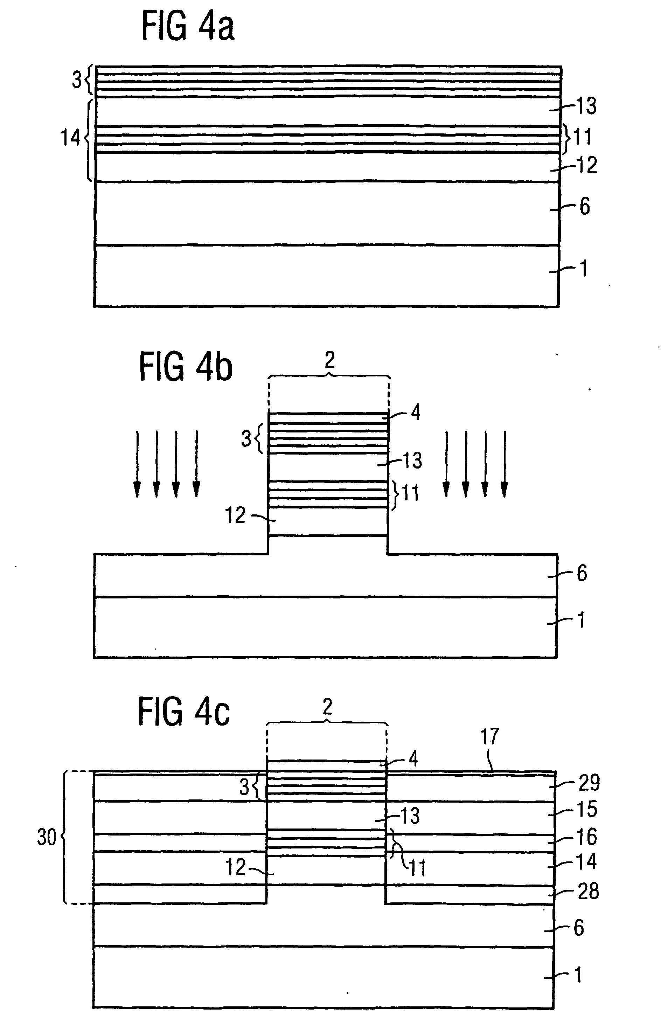

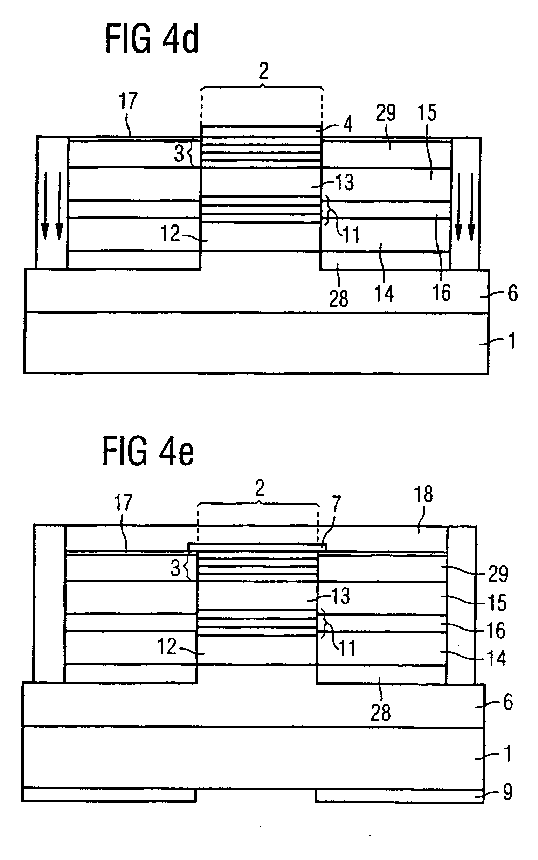

In Figur 4 ist schematisch ein Verfahren zur Herstellung einer erfindungsgemäßen Halbleiterlaservorrichtung gezeigt. Zunächst werden auf das Substrat 1 nacheinander die Bufferschicht 6, die erste Confinementschicht 12, die Quantentopfstruktur 11, die zweite Confinementschicht 13 und die Bragg-Spiegelschichten 3, beispielsweise mittels MOVPE, aufgebracht (Figur 4a).

Danach wird auf den vorgesehenen oberflächenemittierenden Laserbereich 2 dieser Schichtenfolge eine Ätzmaske 4 aufgebracht. Nachfolgend werden außerhalb des vorgesehenen oberflächenemittierenden Laserbereichs 2 die Bragg-Spiegelschichten 3, die Confinementschichten 12 und 13, die Quantentopfstruktur 11 und teilweise die Bufferschicht 6 beispielsweise mittels Ätzung entfernt (Figur 4b).

Auf den freigelegten Bereich der Bufferschicht werden dann die erste Mantelschicht 28, die erste Wellenleiterschicht 14, die aktive Schicht 16, die zweite Wellenleiterschicht 15, die zweite Mantelschicht 29 und die Deckschicht 17 nacheinander, beispielsweise wiederum mittels MOVPE, aufgebracht (Figur 4c).

Anschließend werden die Außenbereiche und der Zentralbereich (nicht dargestellt) der Halbleiterstruktur zur Bildung des totalreflektierenden, geschlossenen Wellenleiters abgetragen. Dies kann beispielsweise durch reaktives Ionenätzen unter Verwendung einer geeigneten, bekannten Maskentechnik erfolgen (Figur 4d).

Die so hergestellten Seitenflächen der kantenemittierenden Halbleiterstruktur erfordern keine optische Vergütung und bilden einen nahezu verlustfreien Ringlaserresonator.

Abschließend wird die Ätzmaske 4 entfernt, auf den Braggspiegel 3 die elektrisch isolierende Maskenschicht 7 aufgebracht und die Oberfläche mit der p-Kontaktschicht 18 abgedeckt. Das Substrat wird mit den n-Kontaktflächen 9 versehen (Figur 4e).

Die Erläuterung der Erfindung anhand der beschriebenen Ausführungsbeispiele ist selbstverständlich nicht als Beschränkung der Erfindung hierauf zu verstehen.

## Patentansprüche

1. Optisch gepumpte oberflächenemittierende Halbleiterlaservorrichtung mit mindestens einer strahlungserzeugenden Quantentopfstruktur (11) und mindestens einer Pumpstrahlungsquelle zum optischen Pumpen der Quantentopfstruktur (11), bei der die Pumpstrahlungsquelle mindestens eine kantenemittierende Halbleiterstruktur (30) aufweist und die mindestens eine kantenemittierende Halbleiterstruktur (30) und die Quantentopfstruktur (11) auf einem gemeinsamen Substrat (1) epitaktisch aufgewachsen sind,
**dadurch gekennzeichnet, daß**
die mindestens eine kantenemittierende Halbleiterstruktur (30) mindestens einen Ringlaser enthält.

2. Halbleiterlaservorrichtung nach Anspruch 1,
**dadurch gekennzeichnet, daß**
die Quantentopfstruktur (11) innerhalb des Resonators des Ringlasers angeordnet ist.

3. Halbleiterlaservorrichtung nach Anspruch 1 oder 2,
**dadurch gekennzeichnet, daß**
der Resonator des Ringlasers von einem ringförmig geschlossenen Wellenleiter gebildet wird.

4. Halbleiterlaservorrichtung nach einem der Ansprüche 1 bis 3,
**dadurch gekennzeichnet, daß**
die kantenemittierenden Halbleiterstruktur (30) von einem Medium umgeben ist, dessen Brechungsindex geringer ist als der Brechungsindex der kantenemittierenden Halbleiterstruktur (30).

5. Halbleiterlaservorrichtung nach einem der Ansprüche 1 bis 4,
**dadurch gekennzeichnet, daß**
die kantenemittierende Halbleiterstruktur (30) von Luft, einem anderen gasförmigen Medium oder einem Dielektrikum umgeben ist.

6. Halbleiterlaservorrichtung nach einem der Ansprüche 1 bis 5,
**dadurch gekennzeichnet, daß**
die kantenemittierende Halbleiterstruktur (30) als zylindrischer Körper mit kreisförmigem oder kreisringförmigem Querschnitt gebildet ist.

7. Halbleiterlaservorrichtung nach einem der Ansprüche 1 bis 5,
**dadurch gekennzeichnet, daß**
die kantenemittierende Halbleiterstruktur (30) als prismatischer Körper mit einem Querschnitt in Form eines Vielecks oder eines Vieleckrings gebildet ist.

8. Verfahren zur Herstellung einer Halbleiterlaservorrichtung nach einem der Ansprüche 1 bis 7,
**gekennzeichnet durch** die Schritte
- Aufbringen einer oberflächenemittierenden Halbleiterschichtenfolge mit mindestens einer Quantentopfstruktur (11) auf ein Substrat (1),
- Entfernen der oberflächenemittierenden Halbleiterschichtenfolge außerhalb eines vorgesehenen Laserbereichs (2),
- Aufbringen einer kantenemittierenden Halbleiterstruktur (30) auf den freigelegten Bereich über dem Substrat (1),
- Entfernen von Teilbereichen der kantenemittierenden Halbleiterstruktur (30) zur Ausbildung des Ringlaserresonators.

9. Verfahren zur Herstellung einer Halbleiterlaservorrichtung nach einem der Ansprüche 1 bis 7,
**gekennzeichnet durch** die Schritte
- Aufbringen einer kantenemittierenden Halbleiterstruktur (30) auf ein Substrat (1),
- Entfernen der kantenemittierenden Halbleiterstruktur (30) innerhalb eines vorgesehenen Laserbereichs (2),
- Aufbringen einer oberflächenemittierenden Halbleiterschichtenfolge mit mindestens einer Quantentopfstruktur (11) auf das Substrat (1) innerhalb des freigelegten Laserbereichs,
- Entfernen von Teilbereichen der kantenemittierenden Halbleiterschichtenfolge (30) zur Ausbildung des Ringlaserresonators.

10. Verfahren nach Anspruch 8 oder 9,
**dadurch gekennzeichnet, daß**
die Entfernung von Teilbereichen der kantenemittierenden Halbleiterstruktur (30) durch Trockenätzen erfolgt.

## Claims

1. Optically pumped surface-emitting semiconductor laser device having at least one radiation-generating quantum well structure (11) and at least one pump radiation source for optically pumping the quantum well structure (11), in which the pump radiation source has at least one edge-emitting semiconductor structure (30) and the at least one edge-emitting semiconductor structure (30) and the quantum well structure (11) are grown epitaxially on a common substrate (1),
**characterized in that**
the at least one edge-emitting semiconductor structure (30) contains at least one ring laser.

2. Semiconductor laser device according to Claim 1,
**characterized in that**
the quantum well structure (11) is arranged within the resonator of the ring laser.

3. Semiconductor laser device according to Claim 1 or 2,
**characterized in that**
the resonator of the ring laser is formed by an annularly closed waveguide.

4. Semiconductor laser device according to one of Claims 1 to 3,
**characterized in that**
the edge-emitting semiconductor structure (30) is surrounded by a medium whose refractive index is less than the refractive index of the edge-emitting semiconductor structure (30).

5. Semiconductor laser device according to one of Claims 1 to 4,
**characterized in that**
the edge-emitting semiconductor structure (30) is surrounded by air, another gaseous medium or a dielectric.

6. Semiconductor laser device according to one of Claims 1 to 5,
**characterized in that**
the edge-emitting semiconductor structure (30) is formed as a cylindrical body with a circular or annular cross section.

7. Semiconductor laser device according to one of Claims 1 to 5,
**characterized in that**
the edge-emitting semiconductor structure (30) is formed as a prismatic body with a cross section in the form of a polygon or a polygonal ring.

8. Method for producing a semiconductor laser device according to one of Claims 1 to 7,
**characterized by** the following steps:
- application of a surface-emitting semiconductor layer sequence with at least one quantum well structure (11) over a substrate (1),
- removal of the surface-emitting semiconductor layer sequence outside an envisaged laser region (2),
- application of an edge-emitting semiconductor structure (30) over the uncovered region above the substrate (1),
- removal of partial regions of the edge-emitting semiconductor structure (30) in order to form the ring laser resonator.

9. Method for producing a semiconductor laser device according to one of Claims 1 to 7,
**characterized by** the following steps:
- application of an edge-emitting semiconductor structure (30) over a substrate (1),
- removal of the edge-emitting semiconductor structure (30) within an envisaged laser region (2),
- application of a surface-emitting semiconductor layer sequence with at least one quantum well structure (11) over the substrate (1) within the uncovered laser region,
- removal of partial regions of the edge-emitting semiconductor layer sequence (30) in order to form the ring laser resonator.

10. Method according to Claim 8 or 9,
**characterized in that**
the removal of partial regions of the edge-emitting semiconductor structure (30) is effected by dry etching.

## Revendications

1. Dispositif laser à semi-conducteur à pompage optique et à émission par la surface comprenant au moins une structure (11) de puits quantique produisant du rayonnement et au moins une source de rayonnement de pompage pour le pompage optique de la structure (11) de puits quantique, dans lequel la source de rayonnement de pompage à au moins une structure (30) à semi-conducteur à émission par le bord et la au moins une structure (30) à semi-conducteur à émission par le bord et la structure (11) de puits quantique sont obtenues par croissance épitaxiale sur un substrat (1) commun,
**caractérisé en ce que** la au moins une structure (30) à semi-conducteur à émission par le bord comporte au moins un laser en anneau.

2. Dispositif laser à semi-conducteur suivant la revendication 1,
**caractérisé en ce que** la structure (11) de puits quantique est placée à l'intérieur du résonateur du laser en anneau.

3. Dispositif laser à semi-conducteur suivant la revendication 1 ou 2,
**caractérisé en ce que** le résonateur du laser en anneau est formé par un guide d'onde fermé annulairement.

4. Dispositif laser à semi-conducteur suivant l'une des revendications 1 à 3,
**caractérisé en ce que** la structure (30) à semi-conducteur à émission par le bord est entourée d'un fluide dont l'indice de réfraction est plus petit que l'indice de réfraction de la structure (30) à semi-conducteur à émission par le bord.

5. Dispositif laser à semi-conducteur suivant l'une des revendications 1 à 4,
**caractérisé en ce que** la structure (30) à semi-conducteur à émission par le bord est entourée d'air, d'un autre fluide gazeux ou d'un diélectrique.

6. Dispositif laser à semi-conducteur suivant l'une des revendications 1 à 5,
**caractérisé en ce que** la structure (30) à semi-conducteur à émission par le bord est constituée sous la forme d'une pièce cylindrique de section transversale circulaire ou annulaire.

7. Dispositif laser à semi-conducteur suivant l'une des revendications 1 à 5,
**caractérisé en ce que** la structure (30) à semi-conducteur à émission par le bord est constituée sous la forme d'une pièce prismatique de section transversale polygonale ou en anneau polygonal.

8. Procédé de production d'un dispositif laser à semi-conducteur suivant l'une des revendications 1 à 7,
**caractérisé par** les stades
- dépôt d'une succession de couches semi-conductrices à émission par la surface comprenant au moins une structure (11) de puits quantique sur un substrat (1),
- élimination de la succession de couches semi-conductrices à émission par la surface à l'extérieur d'une partie 2 prévue de laser,
- dépôt d'une structure (30) à semi-conducteur à émission par le bord sur la partie dénudée sur le substrat (1),
- élimination de sous-parties de la structure (30) à semi-conducteur à émission par le bord pour constituer le résonateur laser en anneau.

9. Procédé de production d'un dispositif laser à semi-conducteur suivant l'une des revendications 1 à 7,
**caractérisé par** les stades
- dépôt d'une structure (30) à semi-conducteur à émission par le bord sur un substrat (1),
- élimination de la structure (30) à semi-conducteur à émission par le bord dans une partie (2) de laser qui est prévue,
- dépôt d'une succession de couches semi-conductrices à émission par le bord comprenant au moins une structure (11) de puits quantique sur le substrat (1) dans la partie de laser mise à nu,
- élimination de sous-parties de la succession (30) de couches semi-conductrices à émission par le bord pour constituer le résonateur à laser en anneau.

10. Procédé suivant la revendication 8 ou 9,
**caractérisé en ce que** l'on effectue l'élimination de sous-parties de la structure (30) à semi-conducteur et à émission par le bord par attaque chimique à sec.
